# FASCICULE DE BREVET EUROPEEN

(11) **EP 2 700 103 B1**
(45) Date de publication et mention de la délivrance du brevet: **01.11.2017**
(21) Numéro de dépôt: 12717402.7
(22) Date de dépôt: 28.03.2012
(51) Int. Cl.: H01L 31/049, B32B 27/08, C08G 81/02

(54) **FILM BI-COUCHES D'UN MODULE PHOTOVOLTAIQUE**
ZWEISCHICHTFILM EINES PHOTOVOLTAIKMODULS
BILAYERED FILM FOR PHOTOVOLTAIC MODULE

(30) Priorité: 18.04.2011 FR 1153328
(43) Date de publication de la demande: 26.02.2014
(73) Titulaire: Arkema France, 92700 Colombes (FR)
(72) Inventeur: DEVISME, Samuel, F-76000 Rouen (FR); BIZET, Stéphane, F-27170 Barc (FR); O'BRIEN, Grégory S., Downingtown, Pennsylvania 19335 (US); LEFEBVRE, Amy A., Pottstown, Pennsylvania 19465 (US); JOUSSET, Dominique, 78830 Bougival (FR); FINE, Thomas, F-69007 Lyon (FR)
(74) Mandataire: Gavin, Pablo
(86) Numéro de dépôt international: PCT/FR2012/050656
(87) Numéro de publication internationale: WO 2012/143636

(56) Documents cités:
- WO-A-2008/043958
- WO-A1-2009/138679
- FR-A1- 2 891 490
- US-A1- 2010 175 742

## Description

### Domaine de l'invention

L'invention a pour objet un film bi-couches (encapsulant - « backsheet ») de modules photovoltaïques présentant des propriétés optimums pour cette application. La présente invention concerne également un module photovoltaïque comprenant, outre le susdit film bi-couches, une couche adjacente formant « frontsheet », plus généralement les trois couches successives notées « frontsheet », encapsulant et « backsheet ».

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

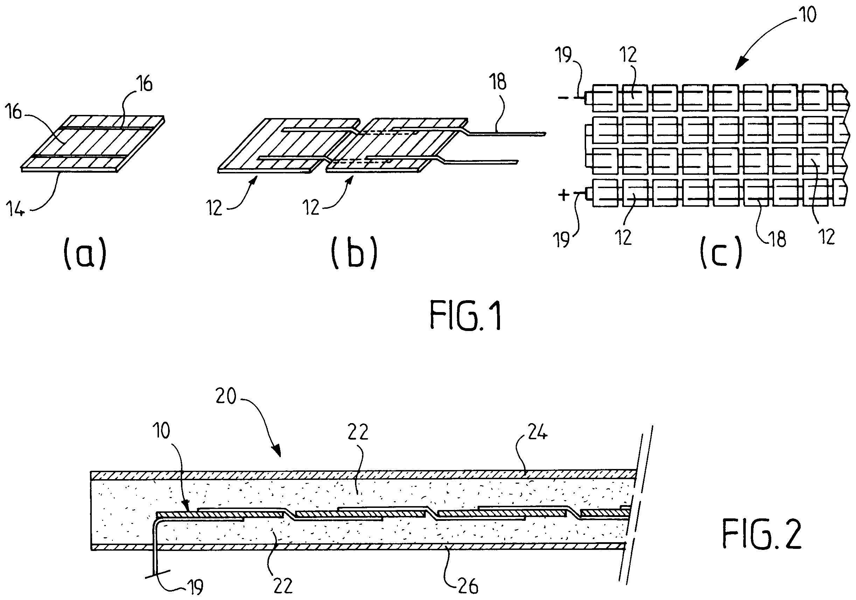

Sur la Figure 1, on a représenté une pile photovoltaïque classique; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure et d'une partie inférieure. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26 contribue à la protection à l'humidité du module photovoltaïque 20 et à l'isolation électrique des cellules 12 pour éviter tout contact avec l'environnement extérieur.

L'encapsulant 22 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 doit également empêcher le contact des cellules 12 avec l'eau et l'oxygène de l'air, afin d'en limiter la corrosion. La partie supérieure de l'encapsulant 22 est comprise entre la pile 10 et la couche protectrice supérieure 24. La partie inférieure de l'encapsulant 22 est comprise entre la pile 10 et le backsheet 26.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

### Etat de l'art

A l'heure actuelle, pour fabriquer un module photovoltaïque, on réalise séparément les trois couches à assembler ensemble, à savoir successivement le « frontsheet », l'encapsulant et le « backsheet ». Ces couches sont associées lors de l'étape de fabrication du module qui est faite le plus souvent par un procédé de lamination sous vide.

Pour promouvoir l'adhésion entre les couches, notamment entre le backsheet et l'encapsulant, on utilise soit des techniques « chimiques » en ajoutant un liant entre les deux couches ou des promoteurs d'adhésion spécifiques, soit des techniques physiques de traitement de surface comme un traitement par effet corona ou plasma.

Ces deux méthodes ne sont pas satisfaisantes car elles consistent, outre un coût additionnel non négligeable (matériau, outils spécifiques, temps de réalisation), en une opération parfois complexe pour un résultat souvent décevant. De plus, les traitements physiques de surface ne sont pas stables dans le temps et nécessitent de prendre des précautions de stockage et de manipulation.

Par ailleurs, l'encapsulant est un matériau qui doit permettre l'incorporation des cellules photovoltaïques au moment de l'assemblage des trois couches (« frontsheet », encapsulant et « backsheet ») du module. Deux principaux types d'encapsulants existent : les thermoplastiques et les réticulables. Dans les deux cas, l'encapsulant est fondu lors de l'étape de lamination du module photovoltaïque afin d'enrober les couches actives.

Outre la manipulation de nombreux films, ce type de procédé de fabrication de module photovoltaïque présente des inconvénients liés au retrait du film d'encapsulant. En effet, il est connu que les films d'encapsulant présentent un retrait qui peut atteindre jusqu'à 10% dans la plupart des cas, voire parfois jusqu'à 50%. Ce retrait peut conduire à des défauts dans le module photovoltaïque tels que des bulles d'air, des plissures, des cloques, des défauts de recouvrement sur les bords ou des ruptures des connecteurs entre cellules. Tous ces défauts sont à l'origine de rebus lors de la fabrication des modules ou peuvent diminuer leur durée de vie et leur efficacité. En effet, les bulles d'air dans l'encapsulant peuvent être à l'origine de points de corrosion diminuant considérablement le cycle de vie ainsi que l'efficacité du module photovoltaïque. Le phénomène de retrait provoque au sein de l'encapsulant des tensions qui peuvent briser une ou plusieurs cellules photovoltaïques et provoquer, en particulier du fait que ces dernières sont montées en série, une détérioration irrémédiable des propriétés de fonctionnement du module photovoltaïque.

Pour limiter ces problèmes, les fabricants de films d'encapsulant sont obligés d'utiliser un procédé d'extrusion comprenant une étape de post-recuit pour limiter ce retrait au détriment de la vitesse d'extrusion et donc du coût des films.

### Brève description de l'invention

La présente invention entend remédier aux problèmes des encapsulants de modules photovoltaïques de l'art antérieur en proposant un film bi-couches réalisé en une opération unique et comportant la couche d'encapsulant et la couche backsheet.

Il a été constaté par la demanderesse, après diverses expériences et manipulations, qu'une structure particulière pouvait seule présenter des résultats optimums permettant de palier aux problèmes liés d'une part au processus de fabrication d'un module et d'autre part aux défauts intrinsèques de l'association des couches encapsulant - backsheet.

Ainsi, la présente invention concerne un film thermoplastique bi-couches d'un module photovoltaïque, comprenant deux couches dont une couche forme l'encapsulant et l'autre couche forme le backsheet, l'ensemble encapsulant-backsheet présentant une épaisseur supérieure à 100 µm (micromètre), caractérisé en ce que :
a) l'encapsulant consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
   - le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation,
   - le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine ;
b) le backsheet comprend une couche formée d'un polymère dont le module d'Young est supérieur ou égal à 1,1 GPa (GigaPascal) selon la norme ASTM D638, de préférence supérieur ou égal à 1,3 Gpa (GigaPascal).

D'autres caractéristiques avantageuses de l'invention sont précisées dans la suite :
- les susdits polymères greffés de l'encapsulant sont nanostructurés ;
- la masse molaire en nombre des susdits greffons polyamide des susdits polymères greffés de l'encapsulant est comprise dans la gamme allant de 1000 à 5000 g/mol, de préférence comprise dans la gamme allant de 2000 à 3000 g.mol-1;
- pour les susdits polymères greffés de l'encapsulant, le nombre de monomère (X) fixé sur le tronc en polyoléfine est supérieur ou égal à 1,3 et/ou inférieur ou égal à 10 ;
- le au moins un greffon en polyamide du polymère greffé de l'encapsulant comprend au moins un copolyamide ;
- le tronc en polyoléfine du polymère greffé de l'encapsulant n'a pas de température de fusion ou a une température de fusion inférieure à 110°C ;
- le copolymère de polyéthylène de la polyoléfine de l'encapsulant est choisi parmi un copolymère éthylène-alphaoléfine dont la densité est comprise entre 0,865 et 0,94 (norme ASTM D 1505), un copolymère d'éthylène-(méth)acrylates d'alkyle-anhydride;
- le backsheet consiste en un polymère formant la couche de backsheet pourra consister en un polyester;
- selon un mode préféré, le backsheet consiste en un polyéthylène téréphtalate (PET) de formule brute (C₁₀H₈O₄)ₙ ou des copolymères dont l'un des polymères est le polyéthylène téréphtalate ;
- Selon une possibilité offerte par l'invention, et particulièrement avantageuse, le backsheet comprend en outre une couche formée d'un polymère fluoré consistant en un homopolymère de vinylidène difluorure ou un copolymère de vinylidène difluorure et au moins un autre monomère fluoré;
- la couche formant backsheet comprend des charges choisis parmi exemples la silice, l'alumine, les carbonates de calcium, les nanotubes de carbone, les fibres de verre ou encore des argiles modifiées ou non modifiées qui sont mélangées à l'ordre nanométrique ;
- la couche formant encapsulant comprend des promoteurs d'adhésion consistant en un ingrédient non polymérique, de nature organique, cristalline ou minéral et plus préférentiellement semi-minéral semi-organique ;
- selon un mode de réalisation de l'invention, le backsheet et l'encapsulant consistent chacun en une couche unique.

L'invention se rapporte à l'utilisation du film tel que décrit ci-dessus dans un module photovoltaïque.

Enfin, l'invention se rapporte aussi à un module photovoltaïque présentant au moins une couche formant encapsulant comportant une pile photovoltaïque apte à générer de l'énergie électrique et une couche formant backsheet, ces deux couches encapsulant-backsheet comprenant le film tel que décrit ci-dessus.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.

### Description détaillée de l'invention

### Encapsulant:

Concernant tout d'abord l'encapsulant, il s'agit du polymère greffé susmentionné.

S'agissant de ce polymère greffé susmentionné, on utilisera également préférentiellement 15 à 30% en masse de greffons polyamide et un nombre de monomères (X) compris entre 1,3 et 10.

La température d'écoulement du polymère greffé polyamide est définie comme la température la plus élevée parmi les températures de fusion et les températures de transition vitreuse des greffons polyamides et du tronc polyoléfine. Le tronc et les greffons sont choisis pour que la température d'écoulement du polymère greffé polyamide soit supérieure ou égale à 75°C et inférieure ou égale à 160°C,.

S'agissant du tronc polyoléfine relativement à l'encapsulant, c'est un polymère comprenant comme monomère une α-oléfine.

On préfère les α-oléfines ayant de 2 à 30 atomes de carbone.

A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

On peut également citer les cyclo-oléfines ayant de 3 à 30 atomes de carbone, préférentiellement de 3 à 20 atomes de carbone, tels que le cyclopentane, le cycloheptène, le norbornène, le 5-méthyl-2-norbomène, le tétracyclododécène, et le 2-méthyl-1,4,5,8-diméthano-1,2,3,4,4a,5,8,8a-octahydronaphthalène; di et polyoléfines, telles que la butadiène, l'isoprène, le 4-méthyl-1,3-pentadiène, le 1,4-pentadiène, 1,5-hexadiène, 1,3-hexadiène, 1,3-octadiène, 1,4-octadiène, 1,5-octadiène, 1,6-octadiène, l'éthylidènenorbomène, le vinyle norbornène, le dicyclopentadiène, le 7-méthyl-1,6-octadiène, le 4-éthylidiène-8-méthyl-1,7-nonadiène, et le 5,9-diméthyl-1,4,8-décatriène; les composés vinyliques aromatiques tels que le mono- ou poly alkylstyrènes (comprenant le styrène, o-méthylstyrène, m-méthylstyrène, p-méthylstyrène, o,p-diméthylstyrène, o-éthylstyrène, m-éthylstyrène et p-éthylstyrène), et les dérivés comprenant des groupes fonctionnels tels que le méthoxystyrène, l'éthoxystyrène, l'acide benzoïque vinylique, le benzoate de méthyle vinyle, l'acétate de benzyle vinyle, l'hydroxystyrène, l'o-chlorostyrène, le p-chlorostyrène, le di-vinyle benzène, le 3-phénylpropène, le 4-phénylpropène, le α-méthylstyrène, le vinyle chloride, le 1,2-difluoroéthylène, le 1,2-dichloroéthylène, le tétrafluoroéthylène, et le 3,3,3-trifluoro-1-propène.

Dans le cadre de la présente invention, le terme d'α-oléfine comprend également le styrène. On préfère le propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé.

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 10.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère éventuel, et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation :
- d'un lactame,
- ou d'un acide alpha, omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha, omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azélaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan®) ; le polylauryllactame (PA12, également commercialisé par ARKEMA sous la marque Rilsan®) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :
- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et d'un diacide aliphatique.

Ainsi, et de manière non limitative, on peut citer les polyamides 6.T, 6.I, MXD.6 ou encore MXD.10.

Les greffons polyamide rentrant enjeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine-diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont mono fonctionnels.

Pour que le greffon polyamide ait une terminaison monoamine, il suffit d'utiliser un limiteur de chaîne de formule : 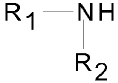 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Avantageusement, les greffons polyamide ont une masse molaire comprise entre 1000 et 5000 g/mol et de préférence entre 2000 et 3000 g/mol.

La polycondensation définie ci-dessus s'effectue selon les procédés habituellement connus, par exemple à une température comprise en général entre 200 et 300°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur mono fonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de (X) s'effectue par réaction d'une fonction amine ou acide du greffon polyamide sur le reste de (X). Avantageusement, on utilise des greffons polyamide monoamine et on crée des liaisons amides ou imides en faisant réagir la fonction amine sur la fonction du reste de (X).

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225.

Le polymère greffé polyamide de la présente invention présente avantageusement une organisation nanostructurée. Pour obtenir ce type d'organisation, on utilisera préférentiellement par exemple des greffons présentant une masse molaire en nombre Mₙ comprise entre 1000 et 5000g/mol et plus préférentiellement entre 2000 et 3000 g/mol.

Des plastifiants pourront être ajoutés à la couche formant l'encapsulant afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des agents retardateurs de flamme pourront également être ajoutés. On pourra également ajouter des composés colorants ou azurants.

De la même manière, des promoteurs d'adhésion, bien que non nécessaires, peuvent être avantageusement ajoutés afin d'améliorer le pouvoir d'adhérence de la composition lorsque celui-ci doit être particulièrement élevé. Le promoteur d'adhésion est un ingrédient non polymérique ; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes, les trialcooxysilane. Avantageusement, on utilisera les trialcooxysilanes contenant un groupement époxy, vinyle et amine en particulier dans le cas où ces promoteurs d'adhésion sont prévus en tant que mélange maître avec l'encapsulant-backsheet selon l'invention. On pourra également prévoir que ces promoteurs d'adhésion sont directement greffés sur la polyoléfine de la couche formant encapsulant par une technique bien connue de l'homme du métier, par exemple l'extrusion réactive.

Le rayonnement UV étant susceptible d'entraîner un léger jaunissement de la composition utilisée en tant qu'encapsulant desdits modules, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,1 à 5%.

De la même manière, des agents retardateurs de flamme peuvent également être ajoutés à la couche encapsulant ainsi qu'à la couche formant le backsheet (décrite ci-dessous). Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

On peut également ajouter à la couche encapsulant des pigments comme par exemple des composés colorants ou azurants dans des proportions allant généralement de 5 à 15% par rapport à la masse totale de la composition.

### Backsheet :

Concernant cette couche du backsheet, il s'agit d'un polymère dont le module d'Young est suéprieur ou égal à 1,1 GPa selon la norme ASTM D638, de préférence supérieur ou égal à 1,3 GPa.

Ce polymère pourra consister en un polyéthylène téréphtalate (PET) de formule brute (C₁₀H₈O₄)ₙ ou des copolymères dont l'un des polymères est le polyéthylène téréphtalate. Ce polymère thermoplastique de la famille des polyesters et peut exister sous sa forme de polymère amorphe ou semi-cristallin. Dans le cadre de la présente invention, le PET est entendu sans restriction quant à sa forme physico-chimique.

Le monomère du PET, le bis-β-hydroxytéréphtalate, est obtenu par des techniques bien connues de l'homme du métier, par exemple par réaction d'estérification entre l'acide téréphtalique et l'éthylène glycol en milieu aqueux ou par réaction de transestérification entre l'éthylène glycol et le diméthyl téréphtalate en solution de méthanol. La polymérisation est également réalisée de façon parfaitement connue et maîtrisée par l'homme du métier par exemple par réaction de polycondensation des monomères, réalisée directement à la suite de l'obtention des monomères.

S'agissant des copolymères à base de polyéthylène téréphtalate, on citera les copolymères PET-CHDM (DiMéthanol CycloHexane) ou PET-polymère d'acide isophtaltique.

De manière générale, le polymère formant la couche de backsheet pourra consister en un polyester (par exemple du poly(éthylène téréphthalates) ou du poly(éthylène naphthalates)), un polycarbonate, une polyoléfine (par exemple du polypropylène, des polyoléfines thermoplastiques, des polyéthylènes haute densité, des polyoléfines cycliques, du polystyrène (par exemple des polystyrènes syndiotactique), des copolymères styrène-acrylate, des copolymères acrylonitrile-styrène (par exemple ABS ou ASA), du polysulfone (par exemples des polyéthersulfones, des polysulfones, etc.), du poly(uréthanes) (éther aliphatique ou ester aliphatique ou éther aromatique ou ester aromatique ou des thermoplastiques de polyuréthanes ester), des acryliques (PMMA), du polychlorure de vinyle (par exemple du polychlorure de vinylidène), du poly(phénylène oxyde) (PPE), des résines à base de polyamide, des résines à base de polyimide, ou des résines à base de polyamide-imide. Bien entendu, le polymère formant le backsheet selon la présente invention peut être constituer d'un mélange de ces composants énumérés non exhaustivement ci-dessus.

Selon une possibilité offerte par l'invention, le backsheet comprendra une couche supplémentaire, adjacente à la susdite couche principale formée par le polymère dont le module est supérieur à 1,1 Gpa (norme ASTM D638), de préférence supérieur Pou égal à 1,3 GPa, consistant en un polymère fluoré tel que notamment un homopolymère de vinylidène difluorure, un copolymère de vinylidène difluorure et au moins un autre monomère fluoré, les copolymères hétérogène de fluorure de vinylidène (VF₂)/comonomère fluoré.

Cette couche additionnelle sera par ailleurs située sans contact avec l'encapsulant, c'est-à-dire du côté opposé à l'encapsulant, de sorte que ce sera toujours la couche de polymère greffé du backsheet qui sera en contact avec la couche formant l'encapsulant.
Le polymère fluoré entrant dans la composition selon l'invention est préparé :
1) soit par polymérisation d'un ou plusieurs monomère(s) de formule (I) : 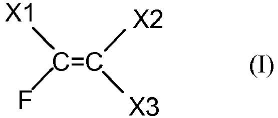 dans laquelle :
   - X₁ désigne H ou F;
   - X₂ et X₃ désignent H, F, Cl, un groupement alkylé fluoré de formule CₙFₘHₚ- ou un groupement alcoxy fluoré CₙFₘHₚO-, n étant un entier compris entre 1 et 10, m un entier compris entre 1 et (2n+1), p valant 2n+1-m.

   Comme exemples de monomères, on peut citer l'hexafluoropropylène (HFP), le tétrafluoroéthylène (TFE), le fluorure de vinylidène (VDF, CH₂=CF₂), le chlorotrifluoroéthylène (CTFE), les éthers vinyliques perfluoroalkyle tels que CF₃-O-CF=CF₂, CF₃-CF₂-O-CF=CF₂ ou CF₃-CF₂CF₂-O-CF=CF₂, le 1-ydropentafluoropropène, le 2-hydro-pentafluoropropène, le dichlorodifluoroéthylène, le trifluoroéthylène (VF₃), le 1,1-dichlorofluoroéthylène et leurs mélanges, les dioléfines contenant du fluor, par exemple les dioléfines telles que l'éther perfluorodiallyle et le perfluoro-1,3-butadiène.
   A titre d'exemples de polymères fluorés, on peut citer :
   - les homo- ou copolymères du TFE, notamment le PTFE (polytétrafluoroéthylène), l'ETFE (copolymère éthylène-tétrafluoroéthylène) ainsi que les copolymères TFE/PMVE (copolymère tetrafluoroéthylène- perfluoro(méthyl vinyl)éther), TFE/PEVE (copolymère tetrafluoroéthylène- perfluoro(éthyl vinyl) éther), TFE/PPVE (copolymère tetrafluoroéthylène- perfluoro(propyl vinyl) éther), E/TFE/HFP (terpolymères éthylène-tétrafluoroéthylène - hexafluoropropylène) ;
   - les homo- ou copolymères du VDF, notamment le PVDF et les copolymères VDF-HFP ;
   - les homo- ou copolymères du CTFE, notamment le PCTFE (polychlorotrifluoroéthylène) et l'E-CTFE (copolymère éthylène-chlorotrifluoroéthylène).

   De préférence, le polymère fluoré est un homopolymère ou un copolymère de VDF.
   Avantageusement, le comonomère fluoré copolymérisable avec le VDF est choisi par exemple parmi le fluorure de vinyle; le trifluoroéthylène (VF3); le chlorotrifluoroethylène (CTFE); le 1,2-difluoroéthylène; le tetrafluoroéthylène (TFE); l'hexafluoropropylène (HFP); les perfluoro(alkyl vinyl) éthers tels que le perfluoro(méthyl vinyl)éther (PMVE), le perfluoro(éthyl vinyl) éther (PEVE) et le perfluoro(propyl vinyl) éther (PPVE); le perfluoro(1,3-dioxole); le perfluoro(2,2-diméthyl-1,3-dioxole) (PDD), et leur mélanges.
   De préférence le comonomère fluoré est choisi parmi le chlorotrifluoroéthylène (CTFE), l'hexafluoropropylène (HFP), le trifluoroéthylène (VF3) et le tétrafluoroéthylène (TFE), et leur mélanges. Le comonomère est avantageusement l'HFP car il copolymérise bien avec le VDF et permet d'apporter de bonnes propriétés thermomécaniques. De préférence, le copolymère ne comprend que du VDF et de l'HFP.
   De préférence, le polymère fluoré est un homopolymère de VDF (PVDF) ou un copolymère de VDF comme VDF-HFP contenant au moins 50% en masse de VDF, avantageusement au moins 75% en masse de VDF et de préférence au moins 90% en masse de VDF. On peut citer par exemple plus particulièrement les homopolymères ou copolymères de VDF contenant plus de 75% de VDF et le complément de HFP suivants : KYNAR® 710, KYNAR® 720, KYNAR® 740, KYNAR FLEX® 2850, KYNAR FLEX® 3120, commercialisés par la société ARKEMA.
   Avantageusement, le homopolymère ou un copolymère de VDF ont une viscosité allant de 100 Pa.s à 3000 Pa.s, la viscosité étant mesurée à 230°C, à un gradient de cisaillement de 100 s⁻¹ à l'aide d'un rhéomètre capillaire. En effet, ce type de polymère est bien adapté à l'extrusion. De préférence, le polymère a une viscosité allant de 500 Pa.s à 2900 Pa.s, la viscosité étant mesurée à 230°C, à un gradient de cisaillement de 100 s⁻¹ à l'aide d'un rhéomètre capillaire.
2) Soit par polymérisation d'un ou plusieurs monomères de formule (I) avec un ou plusieurs monomères alkyle vinyle éther de formule (II) :
   Formule (II) : Monomère alkyle vinyle éther : CH₂=CH(OR) où le groupement R est un groupement alkyle aliphatique ou cycloaliphatique ou un groupement de type -R'OH où R' est un groupement alkyle aliphatique.
   Parmi les polymères fluorés correspondant à cette description, on peut citer les copolymères de chlorotrifluoroéthylène avec un ou plusieurs monomère(s) alkyle vinyle éther commercialisés par la société Asahi Glass sous le nom de Lumiflon^{®}.

Ce type de polymère fluoré peut être réticulé via la réaction de l'hydroxyde du monomère alkyle vinyle éther avec un agent de réticulation. Comme exemple d'agent de réticulation, on peut citer les silanes, les titanates, les isocyanates. Pour promouvoir la réaction entre agent de réticulation et groupement hydroxyde du groupement alkyle vinyle éther, un catalyseur peut être ajouté à la formulation. Par exemple, pour accélérer la réaction entre les groupements hydroxydes du polymère fluoré et un agent de réticulation isocyanate, des catalyseurs à base d'étain, comme le dilaurate de dibutyl étain, peuvent être utilisés.

Dans le cas où le polymère fluoré comprend au moins un pigment, une « charge » est présente soit sous forme d'un polymère additionnel qui peut être un homopolymère ou copolymère de méthacrylate de méthyle (MMA) soit sous forme de particules inorganiques.

S'agissant du polymère de MMA, on utilise avantageusement les homopolymères du méthacrylate de méthyle (MMA) et les copolymères contenant au moins 50% en masse de MMA et au moins un autre monomère copolymérisable avec le MMA.

A titre d'exemple de comonomère copolymérisable avec le MMA, on peut citer par exemple les (méth)acrylates d'alkyle, l'acrylonitrile, le butadiène, le styrène, l'isoprène. Des exemples de (méth)acrylates d'alkyle sont décrits dans KIRK-OTHMER, Encyclopedia of chemical technology, 4ème édition (1991) dans le Vol. 1 pages 292-293 et dans le Vol. 16 pages 475-478.

Avantageusement, le polymère (homopolymère ou copolymère) de MMA comprend en masse de 0 à 20% et de préférence 5 à 15% d'un (méth)acrylate d'alkyle en C₁-C₈, qui est de préférence l'acrylate de méthyle et/ou l'acrylate d'éthyle. Le polymère (homopolymère ou copolymère) de MMA peut être fonctionnalisé, c'est-à-dire qu'il contient par exemple des fonctions acide, chlorure d'acide, alcool, anhydride. Ces fonctions peuvent être introduites par greffage ou par copolymérisation. Avantageusement, la fonctionnalité est en particulier la fonction acide apportée par le comonomère acide acrylique. On peut aussi utiliser un monomère à deux fonctions acide acrylique voisines qui peuvent se déshydrater pour former un anhydride. La proportion de fonctionnalité peut être de 0 à 15% en masse du polymère de MMA par exemple de 0 à 10% en masse..

Le polymère de MMA peut contenir avantageusement au moins un additif modifiant choc. Il existe des qualités commerciales de polymère de MMA dit résistant aux chocs, qui contiennent un additif modifiant choc acrylique sous forme de particules multicouches. L'additif modifiant choc est alors présent dans le polymère de MMA tel qu'il est commercialisé (c'est-à-dire introduit dans la résine de MMA au cours du procédé de fabrication) mais il peut aussi être ajouté lors de la fabrication du film. La proportion d'additif modifiant choc varie de 0 à 30 parts pour 70 à 100 parts de polymère de MMA, le total faisant 100 parts.

Les additifs modifiant choc du type particules multicouches, appelées aussi couramment core-shell (noyau-écorce), comprennent au moins une couche élastomérique (ou molle), c'est-à-dire une couche formée d'un polymère ayant une température de transition vitreuse (Tg) inférieure à -5°C et au moins une couche rigide (ou dure), c'est-à-dire formée d'un polymère ayant une Tg supérieure à 25°C. La taille des particules est en général inférieure au µm et avantageusement comprise entre 50 et 300 nm. On trouvera des exemples d'additif modifiant choc sous forme de particules multicouches de type core-shell dans les documents suivants: EP 1061100 A1, US 2004/0030046 A1, FR-A-2446296 ou US 2005/0124761 A1. On préfère des particules de type core-shell ayant au moins 80% en masse de phase élastomérique molle.

Le MVI (melt volume index ou indice de fluidité en volume à l'état fondu) du polymère de MMA peut être compris entre 2 et 15 cm³/10 min, mesuré à 230°C sous une charge de 3,8 kg.

La teneur en polymère de MMA dans la composition de polymère fluoré est comprise entre 1 et 55% massique, avantageusement entre 5 et 50% massique, préférentiellement entre 10 et 45% massique et de manière encore plus préférée entre 20 et 40% massique.

S'agissant des particules inorganiques, on peut utiliser un oxyde métallique comme par exemple le dioxyde de titane (TiO₂), la silice, le quartz, l'alumine, un carbonate comme par exemple le carbonate de calcium, le talc, le mica, la dolomite (CaCO₃•MgCO₃), la montmorillonite (aluminosilicate), BaSO₄ ZrSiO₄, Fe₃ O₄, et leurs mélanges.

La charge minérale a une fonction d'opacifiant dans le domaine de l'UV/visible. L'action protectrice de la charge est complémentaire de celle de l'absorbeur UV. Une charge de TiO₂ est tout particulièrement préférée de ce point de vue-là.

La charge minérale par exemple de type TiO₂ joue le rôle de filtres solaires pour avoir un film opaque, principalement par diffusion/réflexion des rayons UV, mais également du lumière visible.

La charge minérale peut avoir une autre fonction. Par exemple, elle peut avoir une fonction ignifugeante, comme par exemple l'oxyde d'antimoine (Sb₂O₃, Sb₂O₅), Al(OH)₃, Mg(OH)₂, la huntite (3MgCO₃•CaCO₃), l'hydromagnésite (3MgCO₃• Mg(OH)₂•3H ₂O). Il peut s'agir aussi d'une charge conductrice de l'électricité (par exemple, du noir de carbone ou bien des nanotubes de carbone).

La charge a une taille exprimée en diamètre moyen généralement comprise entre 0,05 µm et 1 mm, avantageusement entre 0,1µm et 700µm, préférentiellement entre 0,2 µm et 500 µm. La teneur en charge minérale dans la composition B est comprise entre 0,1 et 30% massique, avantageusement entre 5 et 28% massique, préférentiellement entre 10 et 27% massique et de manière encore plus préférée entre 15 et 25% massique.

Le backsheet, c'est-à-dire sa première couche et/ou couche principale et son éventuelle couche secondaire, pourra comprendre avantageusement des pigments tels que par exemple du dioxyde de titane, des oxydes de zinc ou des sulfures de zinc. Ces pigments peuvent permettre d'obtenir de meilleures propriétés relativement à la réflexion de la lumière et une meilleure opacité, ce qui permet d'améliorer la quantité d'électricité qui peut être produite par le module photovoltaïque.

Tous ces additifs peuvent être ajoutés directement aux couches du backsheet ou être ajoutés sous la forme d'un mélange maître.

Des charges, en particulier minéral, peuvent également être ajoutées pour améliorer la tenue thermomécanique de la composition. De façon non limitative, on donnera comme exemples la silice, l'alumine ou les carbonates de calcium ou les nanotubes de carbone ou encore les fibres de verre. On pourra utiliser des argiles modifiées ou non modifiées qui sont mélangées à l'ordre nanométrique ; ceci permet d'obtenir une composition plus transparente.

### Réticulation/préparation de l'encapsulant et du backsheet et production d'un film encapsulant-backsheet selon l'invention (destiné à former tout ou partie d'un module photovoltaïque) :

Concernant l'encapsulant, bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation. Cette réticulation peut être effectuée par l'une des nombreuses méthodes connues de l'homme du métier, notamment par l'utilisation d'initiateurs activés thermiquement, par exemple des composés peroxydes et azo, des photoinitiateurs tels que le benzophénone, par des techniques de radiation comportant des rayons lumineux, des rayons UV, des faisceaux d'électrons et des rayons X, de silanes porteurs de fonctions réactives comme un amino silane, un époxy silane, un vinyle silane tel que par exemple le vinyle silane tri-éthoxy ou tri-méthoxy, et de la réticulation par voie humide. Le manuel intitulé « Handbook of polymer foams and technology » supra, aux pages 198 à 204, fournit des enseignements complémentaires auxquels l'homme du métier peut se référer.

La structure multicouche selon l'invention peut être obtenue par des techniques classiques de réalisation de films, feuilles ou plaques. A titre d'exemples, on peut citer les techniques d'extrusion soufflage de gaine (encore appelée « Blown film »), d'extrusion lamination, d'extrusion couchage, d'extrusion de film à plat (encore appelée « cast film ») ou encore d'extrusion de feuilles. Toutes ces techniques sont connues de l'homme de métier et il saura adapter les conditions de mise en oeuvre des différentes techniques (température des extrudeuses, raccord, filières et « feedblock », vitesse de rotation des vis, températures de refroidissement des cylindres de refroidissement, etc..) pour former la structure selon l'invention ayant la forme et les épaisseurs désirées. On ne sortirait pas de l'invention si la structure finale était obtenue par des techniques de pressage, de lamination avec des adhésifs en voie solvant ou aqueuse, ou si la structure finale subissait une étape de recuit supplémentaire.

Enfin, dans le cas spécifique de la structure multicouche comprenant une couche additionnelle de polymère fluoré, on ne sortirait pas de l'invention si la couche fluorée était déposé par enduction (« coating ») en voie aqueuse ou solvant (l'homme du métier pour se référer pour plus de détails au document WO 2010144520).

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

### Matériaux employés pour former les formulations testées :

**Apolhya Solar® LC3UV:** La famille Apolhya Solar® est une famille de polymères commercialisée par ARKEMA qui allient les propriétés des polyamides à celles des polyoléfines grâce à l'obtention de morphologies co-continues à l'échelle manométrique. Dans le cadre des tests, il est retenu ici l'Apolhya Solar® LC3UV qui est un des grades de la famille Apolhya Solar® qui se caractérise par un MFI (« Melt Flow Index») de 10 grammes/10 minutes à 230°C sous 2,16 kg commercialisé par la demanderesse. Ce produit présente un module élastique de 65 MPa (MégaPascal) à température ambiante et un point de fusion de 130°C.

**PET biorienté :** Un PET (polyéthylène téréphtalate) biorienté de 250 µm d'épaisseur de la société a été utilisé comme couche principale de backsheet.

**Kynar film 302 PGM TR :** Film à base de PVDF (polyfluorure de vinylidène) commercialisé par la société Arkema.

**Adhésif Bostik®:** pour le collage du film Kynar ou de l'Apolhya Solar sur le PET, la colle HBTS ESP877 de chez Bostik® a été utilisé en association avec le durcisseur Boscodur 1621.

**Backsheet KPE :** un backsheet Kynar/PET/EVA de la société Flexcon® est utilisé comme backsheet référence.

### Obtention des formulations et films testés:

### • Extrusion d'un film monocouche de 400µm d'Apolhya Solar® LC3UV

Des films monocouches de 400µm (micromètre) ont été réalisés par extrusion de film à plat (CAST) sur une ligne d'extrusion de marque Dr COLLIN®. Cette ligne d'extrusion se compose de trois extrudeuses équipées d'un profil de vis standard polyoléfine, d'un bloc de coextrusion variable (variable « feedblock »), et d'une filière porte manteaux de 250 mm (« coat hanger die »).

Les paramètres procédés suivants ont été utilisés pour l'extrusion du film monocouche de 400 µm d'Apolhya Solar® LC3UV
- T° extrusion : 150°C (degré Celsius),
- T° (température) de la boite de coextrusion et filière : 160°C,
- la vitesse de ligne est de 2,6 m/min (mètre par minute).

### • Réalisation d'un backsheet/encapsulant PET/Apolhya Solar® LC3UV

Le film de PET de 250 µm subit tout d'abord un traitement corona pour « activer » sa surface. Ensuite, 30 µm de colle sont déposés sur le PET traité à l'aide d'un « bar coater ». La colle est un mélange de HBTS ESP 877 et de Boscodur 1621 dans les proportions respectives de 100 parts d'ESP 877 pour 9 parts de Boscodur 1621. Le solvant de la colle est évaporé quelques minutes à 50°C dans une étuve ventilée. A la sortie de l'étuve, un film d'Apolhya Solar LC3UV, également traité corona, est laminé à la main sur le PET enduit de colle. L'ensemble est ensuite pressé dan une presse chauffante à 80°C pendant 5 minutes. Enfin, l'assemblage PET/colle/LC3UV est post-cuit pendant 3 jours à 60°C.

### Tests réalisés sur les films:

### Assemblage de mini-modules tests

Des mini modules tests ont été assemblés à l'aide d'un laminateur de laboratoire de la société Penergy®. Deux types de mini modules tests ont été réalisés. Le premier type consiste à empiler successivement sur une couche de verre de 3 mm, une couche de LC3UV de 400 µm, un morceau de couche active en silicium cristallin et les connecteurs métalliques, une seconde couche de LC3UV et enfin une couche de backsheet KPE. Le second type consiste à empiler successivement sur une couche de verre de 3 mm, une couche de LC3UV de 400 µm, un morceau de couche active en silicium cristallin et les connecteurs métalliques et enfin la couche de backsheet-encapsulant PET/LC3UV.
Pour les deux types de structure, le cycle de lamination appliqué est le suivant:
- 1^{ère} étape: dégazage à 150°C pendant 300 secondes
- 2^{ème} étape: pressage à 150°C pendant 160 secondes
La qualité des modules est évaluée au travers du nombre de défauts visibles à l'oeil nu tels que les plissures, les bulles, les cloques, les ruptures de connecteurs, ....

On notera que le film selon l'invention est défini à minima par l'association d'une couche d'encapsulant et d'une couche backsheet telles que définies précédemment. L'intérêt de l'invention, définie en tant que film bi-couches à un composant unique dans chacune desdites couches, est démontré au regard de l'association de compositions formant d'une part l'encapsulant et d'autre part le backsheet mais il est bien entendu que les qualités intrinsèques de ce film selon l'invention pourront être améliorées substantiellement, notamment par l'ajout d'une couche de PVDF à la couche formant le backsheet et/ou par l'ajout d'additifs à fonctionnalité spécifique.

De la même manière, les exemples de film selon l'invention présentent tous les mêmes épaisseurs concernant la couche de peau et celle de coeur mais il est bien entendu que l'homme du métier pourra les faire varier en fonction de l'application du module photovoltaïque et des performances de ce dernier au regard des propriétés intrinsèques de l'encapsulant et du backsheet, nonobstant la synergie réalisée entre les éléments formant d'une part l'encapsulant et d'autre par le backsheet.

La présente invention est illustrée plus en détail par les exemples non limitatifs suivant.
Exemple 1 : Mini-module test obtenu par l'assemblage en laminateur d'un empilement d'une plaque de verre de 3 mm, d'une première couche de LC3UV de 400µm, d'une cellule de silicium cristallin + connecteurs, d'une couche d'encapsulant/backsheet LC3UV/PET.
Exemple comparatif 1 : Mini-module test obtenu par l'assemblage en laminateur d'une plaque de verre de 3 mm, d'une première couche de LC3UV de 400µm, d'une cellule de silicium cristallin + connecteurs, d'une second couche de LC3UV et d'un backsheet KPE.

### Résultats des tests réalisés:

| | Présences de zones de sous épaisseur de l'encapsulant | Présences de zones de verre ou de silicium non couverte par l'encapsulant |
|---|---|---|
| Exemple 1 | 0/10 | 0/10 |
| Exemple Comparatif 1 | 9/10 | 7/10 |

## Revendications

1. Film thermoplastique bi-couches d'un module photovoltaïque, comprenant deux couches dont une couche forme l'encapsulant (22) et l'autre couche forme le backsheet (26), l'ensemble encapsulant-backsheet (22, 26) présentant une épaisseur supérieure à 100 µm (micromètre), **caractérisé en ce que** :
a) l'encapsulant (22) consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
- le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation,
- le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine ;
b) le backsheet (26) comprend une couche formée d'un polymère dont le module d'Young est supérieur à 1,1 GPa (norme ASTM D638), de préférence supérieur ou égal à 1,3 GPa.

2. Film selon la revendication 1, **caractérisé en ce que** les susdits polymères greffés de l'encapsulant (22) sont nanostructurés.

3. Film selon la revendication 1 ou 2, **caractérisé en ce que** la masse molaire en nombre des susdits greffons polyamide des susdits polymères greffés de l'encapsulant (22) est comprise dans la gamme allant de 1000 à 5000 g/mol, de préférence comprise dans la gamme allant de 2000 à 3000 g.mol-1.

4. Film selon l'une quelconque des revendications précédentes, **caractérisé en ce que**, pour les susdits polymères greffés de l'encapsulant (22), le nombre de monomère (X) fixé sur le tronc en polyoléfine est supérieur ou égal à 1,3 et/ou inférieur ou égal à 10.

5. Film selon l'une quelconque des revendications précédentes, **caractérisé en ce que** le au moins un greffon en polyamide du polymère greffé de l'encapsulant (22) comprend au moins un copolyamide.

6. Film selon l'une quelconque des revendications précédentes, **caractérisé en ce que** le tronc en polyoléfine du polymère greffé de l'encapsulant (22) n'a pas de température de fusion ou a une température de fusion inférieure à 110°C.

7. Film selon l'une quelconque des revendications précédentes, **caractérisé en ce que** le copolymère de polyéthylène de la polyoléfine de l'encapsulant (22) est choisi parmi un copolymère éthylène-alphaoléfine dont la densité est comprise entre 0,865 et 0,94 (norme ASTM D 1505), un copolymère d'éthylène-(méth)acrylates d'alkyle-anhydride.

8. Film selon l'une quelconque des revendications précédentes, **caractérisé en ce que** le backsheet (26) consiste en un polymère formant la couche de backsheet pourra consister en un polyester.

9. Film selon la revendication 8, **caractérisé en ce que** le backsheet (26) consiste en un polyéthylène téréphtalate (PET) de formule brute (C₁₀H₈O₄)ₙ ou des copolymères dont l'un des polymères est le polyéthylène téréphtalate.

10. Film selon l'une quelconque des revendications précédentes, **caractérisé en ce que** le backsheet (26) comprend en outre une couche formée d'un polymère fluoré consistant en un homopolymère de vinylidène difluorure ou un copolymère de vinylidène difluorure et au moins un autre monomère fluoré.

11. Film selon l'une quelconque des revendications précédentes, **caractérisé en ce que** la couche formant backsheet (26) comprend des charges choisis parmi exemples la silice, l'alumine, les carbonates de calcium, les nanotubes de carbone, les fibres de verre ou encore des argiles modifiées ou non modifiées qui sont mélangées à l'ordre nanométrique.

12. Film selon l'une quelconque des revendications précédentes, **caractérisé en ce que** la couche formant encapsulant comprend des promoteurs d'adhésion consistant en un ingrédient non polymérique, de nature organique, cristalline ou minéral et plus préférentiellement semi-minéral semi-organique.

13. Film selon l'une des revendications précédentes, **caractérisé en ce que** le backsheet (26) et l'encapsulant (22) consistent chacun en une couche unique.

14. Utilisation du film selon l'une quelconque des revendications précédentes dans un module photovoltaïque.

15. Module photovoltaïque (20) présentant au moins au moins une couche formant encapsulant (22) comportant une pile photovoltaïque (10) apte à générer de l'énergie électrique et une couche formant backsheet (26), ces deux couches encapsulant-backsheet comprenant le film (22, 26) selon l'une quelconque des revendications 1 à 13.

## Patentansprüche

1. Zweischichtige thermoplastische Folie eines Photovoltaikmoduls, umfassend zwei Schichten, von denen eine Schicht die Verkapselung (22) bildet und die andere Schicht die Rückseitenabdeckung (26) bildet, wobei die Verkapselung-Rückseitenabdeckung-Anordnung (22, 26) eine Dicke von mehr als 100 µm (Mikrometer) aufweist, **dadurch gekennzeichnet, dass**:
a) die Verkapselung (22) aus einem Polyamid-Pfropfpolymer mit einer Polyolefin-Hauptkette, die 50 bis 95 Gew.-% des Polyamid-Pfropfpolymers ausmacht und einen Rest mindestens eines ungesättigten Monomers (X) enthält, und mindestens einem Polyamid-Pfropfanteil, der 5 bis 50 Gew.-% des Polyamid-Pfropfpolymers ausmacht, besteht, wobei:
- der Polyamid-Pfropfanteil über den Rest des ungesättigten Monomers (X) mit einer Funktion, die durch eine Kondensationsreaktion mit einem Polyamid mit mindestens einer Aminendgruppe und/oder mindestens einer Carbonsäureendgruppe reagieren kann, an die Polyolefin-Hauptkette gebunden ist,
- der Rest des ungesättigten Monomers (X) durch Pfropfung oder Copolymerisation an der Hauptkette fixiert ist,
- die Polyolefin-Hauptkette und der Polyamid-Pfropfanteil so gewählt sind, dass das Polyamid-Pfropfpolymer eine Fließtemperatur größer gleich 75°C und kleiner gleich 160°C aufweist, wobei diese Fließtemperatur als die höchste Temperatur unter den Schmelztemperaturen und Glasübergangstemperaturen des Polyamid-Pfropfanteils und der Polyolefin-Hauptkette definiert ist;
b) die Rückseitenabdeckung (26) eine Schicht aus einem Polymer mit einem youngschen Elastizitätsmodul von mehr als 1,1 GPa (ASTM-Norm D638) und vorzugsweise größer gleich 1,3 GPa umfasst.

2. Folie nach Anspruch 1, **dadurch gekennzeichnet, dass** die obigen Pfropfpolymere der Verkapselung (22) nanostrukturiert sind.

3. Folie nach Anspruch 1 oder 2, **dadurch gekennzeichnet, dass** das zahlenmittlere Molekulargewicht der obigen Polyamid-Pfropfanteile der obigen Pfropfpolymere der Verkapselung (22) im Bereich von 1000 bis 5000 g/mol und vorzugsweise im Bereich von 2000 bis 3000 g.mol-1 liegt.

4. Folie nach einem der vorhergehenden Ansprüche, **dadurch gekennzeichnet, dass** für die obigen Pfropfpolymere der Verkapselung (22) die Zahl der an der Polyolefin-Hauptkette fixierten Monomere (X) größer gleich 1,3 und/oder kleiner gleich 10 ist.

5. Folie nach einem der vorhergehenden Ansprüche, **dadurch gekennzeichnet, dass** der mindestens eine Polyamid-Pfropfanteil des Pfropfpolymers der Verkapselung (22) mindestens ein Copolyamid umfasst.

6. Folie nach einem der vorhergehenden Ansprüche, **dadurch gekennzeichnet, dass** die Polyolefin-Hauptkette des Pfropfpolymers der Verkapselung (22) keine Schmelztemperatur oder eine Schmelztemperatur von weniger als 110°C aufweist.

7. Folie nach einem der vorhergehenden Ansprüche, **dadurch gekennzeichnet, dass** das Polyethylen-Copolymer des Polyolefins der Verkapselung (22) aus einem Ethylen-alpha-Olefin-Copolymer mit einer Dichte zwischen 0,865 und 0,94 (ASTM-Norm D 1505), einem Ethylen-Alkyl(meth)acrylat-Anhydrid-Copolymer ausgewählt ist.

8. Folie nach einem der vorhergehenden Ansprüche, **dadurch gekennzeichnet, dass** die Rückseitenabdeckung (26) aus einem Polymer besteht, das die Rückseitenabdeckungsschicht bildet, aus einem Polyester bestehen kann.

9. Folie nach Anspruch 8, **dadurch gekennzeichnet, dass** die Rückseitenabdeckung (26) aus einem Polyethylenterephthalat (PET) der Summenformel (C₁₀H₈O₄)ₙ oder Copolymeren, wobei eines der Polymere davon Polyethylenterephthalat ist, besteht.

10. Folie nach einem der vorhergehenden Ansprüche, **dadurch gekennzeichnet, dass** die Rückseitenabdeckung (26) außerdem eine Schicht aus einem Fluorpolymer, das aus einem Vinylidendifluorid-Homopolymer oder einem Copolymer von Vinylidendifluorid und mindestens einem anderen Fluormonomer besteht, umfasst.

11. Folie nach einem der vorhergehenden Ansprüche, **dadurch gekennzeichnet, dass** die die Rückseitenabdeckung (26) bildende Schicht Füllstoffe umfasst, die aus Beispielen Siliciumdioxid, Aluminiumoxid, Calciumcarbonaten, Kohlenstoffnanoröhrchen, Glasfasern oder auch modifizierten oder nicht modifizierten Tonen ausgewählt sind, die im Nanometermaßstab gemischt sind.

12. Folie nach einem der vorhergehenden Ansprüche, **dadurch gekennzeichnet, dass** die eine Verkapselung bildende Schicht Haftvermittler umfasst, die aus einem nicht polymeren Bestandteil organischer, kristalliner oder mineralischer Natur und weiter bevorzugt halbmineralischer halborganischer Natur bestehen.

13. Folie nach einem der vorhergehenden Ansprüche, **dadurch gekennzeichnet, dass** die Rückseitenabdeckung (26) und die Verkapselung (22) jeweils aus einer einzigen Schicht bestehen.

14. Verwendung der Folie nach einem der vorhergehenden Ansprüche in einem Photovoltaikmodul.

15. Photovoltaikmodul (20) mit mindestens mindestens einer eine Verkapselung (22) bildenden Schicht, die eine zur Erzeugung von elektrischer Energie befähigte Photovoltaikzelle (10) umfasst, und eine eine Rückseitenabdeckung (26) bildende Schicht, wobei die beiden Verkapselung/Rückseitenabdeckung-Schichten die Folie (22, 26) nach einem der Ansprüche 1 bis 13 umfassen.

## Claims

1. Double-layer thermoplastic film for a photovoltaic module, comprising two layers, of which one layer forms the encapsulant (22) and the other layer forms the backsheet (26), the encapsulant-backsheet assembly (22, 26) having a thickness of greater than 100 µm (micrometre), **characterized in that**:
a) the encapsulant (22) consists of a polyamide graft polymer comprising a polyolefin backbone, representing from 50% to 95% by weight of the polyamide graft polymer, containing a residue of at least one unsaturated monomer (X) and at least one polyamide graft, representing from 5% to 50% by weight of said polyamide graft polymer, wherein:
- the polyamide graft is attached to the polyolefin backbone by the residue of the unsaturated monomer (X) comprising a function capable of reacting via a condensation reaction with a polyamide having at least one amine end group and/or at least one carboxylic acid end group,
- the residue of the unsaturated monomer (X) is attached to the backbone by grafting or copolymerization,
- the polyolefin backbone and the polyamide graft being chosen so that said polyamide graft polymer has a flow temperature of greater than or equal to 75°C and less than or equal to 160°C, this flow temperature being defined as the highest temperature among the melting temperatures and glass transition temperatures of the polyamide graft and of the polyolefin backbone;
b) the backsheet (26) comprises a layer formed from a polymer with a Young's modulus of greater than 1.1 GPa (ASTM D638 standard), preferably greater than or equal to 1.3 GPa.

2. Film according to Claim 1, **characterized in that** the aforesaid graft polymers of the encapsulant (22) are nanostructured.

3. Film according to Claim 1 or 2, **characterized in that** the number-average molar mass of the aforesaid polyamide grafts of the aforesaid graft polymers of the encapsulant (22) is within the range extending from 1000 to 5000 g/mol, preferably within the range extending from 2000 to 3000 g.mol⁻¹.

4. Film according to any one of the preceding claims, **characterized in that**, for the aforesaid graft polymers of the encapsulant (22), the number of monomers (X) attached to the polyolefin backbone is greater than or equal to 1.3 and/or less than or equal to 10.

5. Film according to any one of the preceding claims, **characterized in that** the at least one polyamide graft of the graft polymer of the encapsulant (22) comprises at least one copolyamide.

6. Film according to any one of the preceding claims, **characterized in that** the polyolefin backbone of the graft polymer of the encapsulant (22) does not have a melting temperature or has a melting temperature below 110°C.

7. Film according to any one of the preceding claims, **characterized in that** the copolymer of polyethylene of the polyolefin of the encapsulant (22) is chosen from an ethylene/α-olefin copolymer, the density of which is between 0.865 and 0.94 (ASTM D 1505 standard), or an ethylene/alkyl (meth)acrylates/ anhydride copolymer.

8. Film according to any one of the preceding claims, **characterized in that** the backsheet (26) consists of a polymer which forms the backsheet layer may consist of a polyester.

9. Film according to Claim 8, **characterized in that** the backsheet (26) consists of a polyethylene terephthalate (PET) of empirical formula (C₁₀H₈O₄)ₙ or copolymers of which one of the polymers is polyethylene terephthalate.

10. Film according to any one of the preceding claims, **characterized in that** the backsheet (26) also comprises a layer formed from a fluoropolymer consisting of a homopolymer of vinylidene difluoride or a copolymer of vinylidene difluoride and at least one other fluoromonomer.

11. Film according to any one of the preceding claims, **characterized in that** the layer forming a backsheet (26) comprises fillers chosen from examples silica, alumina, calcium carbonates, carbon nanotubes, glass fibres or else modified or unmodified clays, which are mixed on the nanometre scale.

12. Film according to any one of the preceding claims, **characterized in that** the layer forming an encapsulant comprises adhesion promoters consisting of a non-polymeric ingredient, of organic, crystalline or mineral nature, and more preferably of semi-mineral, semi-organic nature.

13. Film according to one of the preceding claims, **characterized in that** the backsheet (26) and the encapsulant (22) each consist of a single layer.

14. Use of the film according to any one of the preceding claims in a photovoltaic module.

15. Photovoltaic module (20) having at least at least one layer forming an encapsulant (22) comprising a photovoltaic cell (10) capable of generating electrical energy and one layer forming a backsheet (26), these two encapsulant/backsheet layers comprising the film (22, 26) according to any one of Claims 1 to 13.
